# EUROPEAN PATENT APPLICATION

(11) **EP 3 579 284 A1**
(43) Date of publication of application: **11.12.2019**
(21) Application number: 18290064.7
(22) Date of filing: 08.06.2018
(51) Int. Cl.: H01L 31/0224, H01L 31/18, H01L 31/0352

(54) **METHOD TO OBTAIN A PHOTOVOLTAIC DEVICE**

(71) Applicant: Total SA, 92400 Courbevoie (FR)
(72) Inventor: Drahi, Etienne, 75014 Paris (FR)
(74) Representative: Croonenbroek, Thomas Jakob

(57) **Abstract**

The invention has for object a method for manufacturing a photovoltaic device (15) having metallic front contacts (17), comprising the steps:
• providing a mono- or multicrystalline silicon substrate (1) comprising a predetermined quantity of a dopant and having a front surface (3) and a back surface (5), said dopant comprising either a p-type dopant or a n-type dopant,
• forming a silicon oxide layer (9) on the front surface (3) of the substrate (1),
• opening the silicon oxide layer (9) to form openings or trenches (11) according to a contact pattern,
• depositing a layer of dopant containing silicon (13) on the front surface (3), forming microcrystalline or polycrystalline silicon on top of the openings (11) and amorphous or nanocrystalline silicon on the rest of the front surface (3),
• annealing the layer of dopant containing silicon (13),
• adding metallic contacts (17) on the contact pattern.

## Description

### FIELD OF INVENTION

The invention relates to a method for manufacturing a photovoltaic device, in particular for manufacturing a front contact photovoltaic device.

### BACKGROUND AND PRIOR ART

Photovoltaic devices with front contacts are well known in the art. For example US20050189015, US20110139230 and US6091021 disclose silicon wafer based photovoltaic devices including a front contact or front electrodes. By convention, a front side or surface of a photovoltaic device is the side through which the sunlight penetrates for generation of an electrical current by the photovoltaic effect at the p-n / n-p junction of the photovoltaic device. The backside or back-surface of the photovoltaic device is the side opposite to the front side.

Typically, the front electrical contacts are made of metal, deposited on one or more passivation layers at the front surface of the photovoltaic device.

Application techniques of front electrical contacts may include in particular printing and firing through of contacts by depositing a pattern using serigraphy or ink-jet printing with inks containing a solution of metallic particles, which is then heat-cured. A firing step then makes the electrical contacts penetrate through the passivation layer or layers.

The firing through of the electrical contacts requires heating of the cell, at temperatures generally over 800°C - 900°C to cause penetration of the electrical contacts to form a contact with the underlying semiconductor wafer material.

However, the heat treatment stimulates the penetration of metallic atoms in the silicon substrate. In case of shallow emitters with low doping concentration, the penetration by the metallic atoms causes notably increased recombination and therefore loss of efficiency of the photovoltaic device.

To counterbalance the recombination due to the presence of metallic atoms, local n- or p-doping in higher concentrations around the contact areas can be generated.

The article "Laser-assisted Selective Emitters and the Role of Laser Doping" by F. Colville (Photovoltaics International PVI5-01_3 - 2010) discloses to use heating on, for example, screen printed phosphorous doped paste, to make so-called buried contacts using laser ablation to create trenches in which the contacts are buried, diffusion masking and single-step laser doping.

Colville discloses the use of a dopant containing layer, as an "extra 'film' or layer". Colville also discloses the use of laser to simultaneously perform front surface scribing of a dopant containing silicon nitride SiNₓ film to perform localized high doping. The presence of a significant nitrogen concentration in the film that serves as dopant source causes migration of part of said nitrogen atoms in the substrate, which makes this technique for generating increased doping difficult.

In most cases, the dopants come from an intermediate, functional doping layer, which must be etched away in costly fashion before additional passivation and/or antireflective coatings are applied, since it absorbs light if left in place.

However, the additional steps to generate the local doping, using for example liquid deposition and thermal migration or ion implantation, cause increased production costs.

With the method using a laser to drive dopant in the underlying substrate numerous parameters must be finely tuned, like pulse power, focusing, pulse duration and frequency etc. Also, dopant concentration fluctuation may remain along a scribing line due in particular to the mere fact that laser pulses are used.

Also, the sublimated and remolten portions of dopant may vary, causing further dopant concentration variations, which are hard to control when using laser ablation to drive dopant into the substrate.

Thus, it will be appreciated that there exists a need in the art for an improved method for manufacturing efficient electrical front contacts for a photovoltaic device at competitive costs.

### SUMMARY OF THE INVENTION

In order to overcome the aforementioned drawbacks, the invention has for object a method for manufacturing a photovoltaic device having metallic front contacts, comprising the steps:
- providing a mono- or multicrystalline silicon substrate comprising a predetermined quantity of a dopant and having a front surface and a back surface, said dopant comprising either a p-type dopant or a n-type dopant,
- forming a silicon oxide layer on the front surface of the substrate,
- opening the silicon oxide layer to form openings or trenches according to a contact pattern,
- depositing a layer of dopant containing silicon on the front surface, forming polycrystalline or crystalline silicon on top of the openings and amorphous or microcrystalline silicon on the rest of the front surface,
- annealing the layer of dopant containing silicon,
- adding metallic contacts on the contact pattern.

This method allows in particular to obtain a photovoltaic device in a reduced number of steps, which can almost exclusively be carried out under atmospheric pressure or only partial vacuum. Also, a dopant gradient profile of better quality is obtained with more controlled experimental parameters.

The method may further present one or more of the following characteristics, taken separately or in combination.

The dopant containing silicon may be deposited using plasma enhanced chemical vapour deposition.

The openings or trenches may be performed using laser ablation.

The openings or trenches may be performed using chemical etching.

The method may further comprise the steps of:
∘ depositing an additional passivation or antireflection coating layer,
∘ opening the additional passivation or antireflection coating layer to create second openings along the contact pattern,
_{∘} adding the metallic contacts in the second openings.

The method may further comprise the steps of:
∘ depositing an additional passivation or antireflection coating layer while preserving second openings along the contact pattern,
∘ adding the metallic contacts in the second openings.

The method may further comprise the steps of:
∘ depositing an additional passivation or antireflection coating layer,
∘ adding a paste containing metallic and glass particles on the intended contact pattern,
∘ firing through of the paste containing metallic and glass particles to obtain the metallic contacts.

The additional passivation or antireflection coating layer may comprise at least one layer of material selected from the following list: silicon nitride SiNₓ, silicon carbide SiC, boro- or phosphosilicate glass.

The dopant contained in the dopant containing silicon may be respectively boron or phosphorus, and the additional passivation or antireflection coating layer comprises a layer of respectively boro- or phosphosilicate glass, deposited on the dopant containing silicon layer before the step of annealing the layer of dopant containing silicon to form a layer of polycrystalline silicon and cause a portion of the dopant to diffuse.

The phospho- or borosilicate glass may contain respectively phosphorus or boron atoms as dopant, with a concentration comprised between 5.10¹⁸ and 2.10²¹cm⁻¹.

The additional passivation or antireflection coating layer may be deposited using plasma enhanced chemical vapour deposition.

The dopant containing silicon layer may have a thickness comprised between 5 and 30nm, in particular between 15 and 25nm.

### BRIEF DESCRIPTION OF THE DRAWINGS

Other characteristics and benefits of the invention will appear in the following description based on the enclosed figures among which:
- figure 1 is a linear flow chart of the main steps of a first embodiment of the method according to the invention,
- figures 2 to 8 illustrate the main steps of the method in figure 1,
- figures 9 and 10 illustrate an alternate embodiment of the method,
- figures 11 to 13 illustrate a possible back-surface treatment for the photovoltaic device.

### DETAILED DESCRIPTION

The embodiments described hereafter are given in an illustrating example and are not limited to them. The description refers to particular embodiments, but further embodiments can be obtained by combining or slightly altering features for example of two different embodiments. Said other embodiments are also within the scope of the invention. On all figures, the same reference applies to a single element or equivalent elements.

Furthermore, as the invention relates in particular to the front side of the photovoltaic device, the description hereafter focuses on the steps relating to front side. An example of steps for realisation of the backside of the photovoltaic device is given in an illustrative fashion.

The starting point of the process 100 is a semiconductor substrate 1, in particular a doped silicon wafer. The semiconductor substrate 1 may in particular be a monocrystalline or a polycrystalline silicon wafer.

The silicon substrate 1 comprises a predetermined quantity of a dopant which is either a p-type dopant (like boron for example) or an n-type dopant (like phosphorus for example). The provided silicon substrate 1 has also undergone a saw damage removal process like polishing before application of the next processing steps.

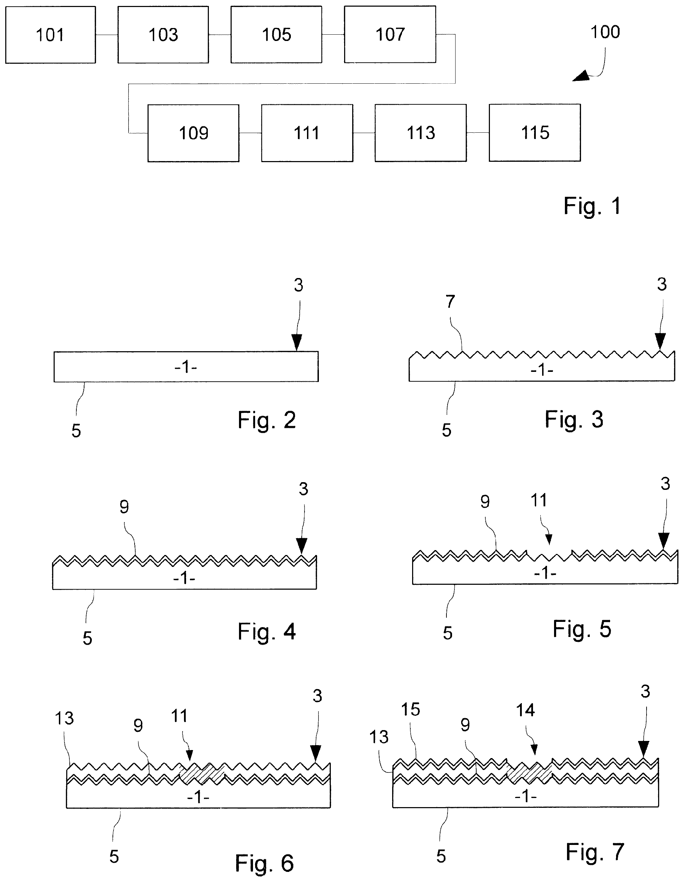

In a first step 101, a silicon substrate 1 is provided (see figure 2) having a front surface 3 and a back surface 5. The silicon substrate 1 is preferentially made of mono-crystalline silicon, but may also be made of multicrystalline silicon.

As already stated, the front surface 3 is the face that is impacted first by the sunlight rays.

In a second step 103, the front surface 3 of silicon substrate 1 is textured (see figure 3) for example with randomly distributed upright tetrahedral pyramids 7. The pyramids consists for example of four planes and four edges with an angle between the planes and the base of about 54,75°.

Random texturing may be formed by submitting {100} silicon wafers to a lowly concentrated alkaline solution buffered with isopropyl alcohol (IPA) and containing dissolved silicon at elevated temperature. The conditions are controlled in a way to ensure that the pyramids 7 have for example a height between 1 and 10µm.

Texturing is illustrated on figure 3 by a saw-tooth profile of the front surface 3 for improved light trapping. However, other texturing methods may be used like for example in WO2011/023894 in the name of the applicant and enclosed by reference. Although generally realized on wafers to trap sunlight more efficiently, the texturing step is highly recommended with respect to the present invention but not necessary for its functioning.

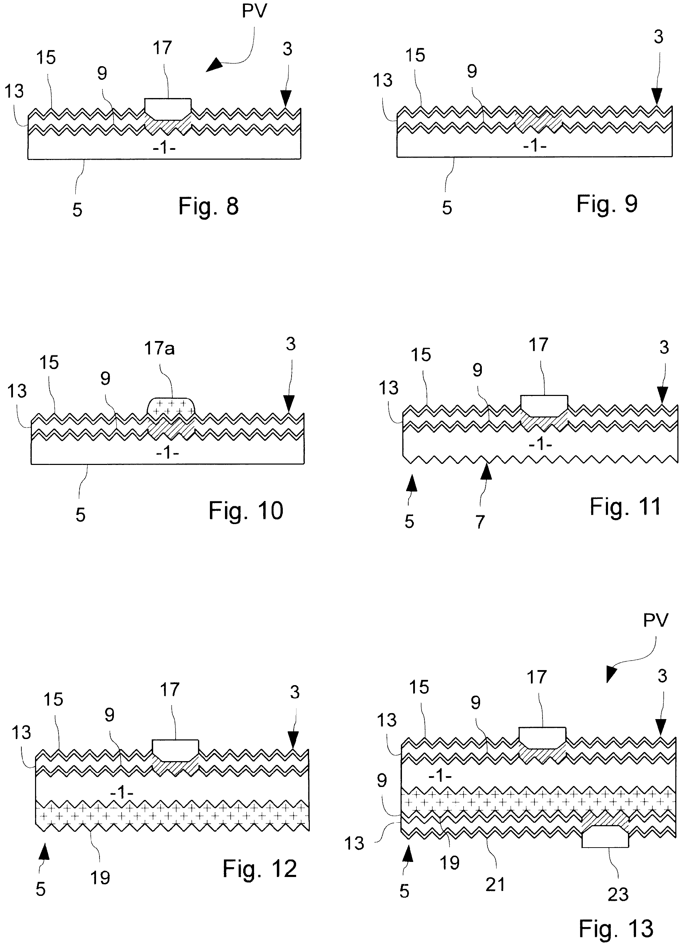

Texturing the back surface 5 can be realized to improve light trapping (see figures 9 to 11).

Texturing the back surface 5 may be done using alkaline etching of random pyramids as with the front surface 3.

The third step 105, illustrated in figure 4, is the formation of a silicon oxide layer 9 on the front surface. The silicone oxide has a thickness comprised between 1 and 10nm, generally 1 to 2.5nm. The aforementioned values lead to an oxide layer 9 through which light can penetrate and charge carriers can tunnel while significantly slowing down surface recombination and dopant atoms diffusion.

The silicon oxide is either added, for example by sputtering or chemical vapor deposition, or grown by oxidation of a topmost layer of the silicon substrate 1.

In particular, the oxide layer can be deposited or grown in atmospheric pressure conditions, without requiring vacuum. Methods to deposit the oxide comprise for example plasma enhanced chemical vapour deposition (PECVD). The oxide layer can also be grown using thermal oxidation (ultra high purity "UHP" steam or molecular oxygen at 800°C to 1200°C). Both methods suggested above can be applied under atmospheric or near atmospheric pressures.

In a fourth step 107 the deposited oxide layer 9 is opened, using for example laser ablation or chemical etching, using for example hydrofluoric acid (HF), to form openings 11 or trenches, according to the intended contact pattern.

The openings 11 can, as an alternative be obtained by laser ablation of the oxide layer 9, performed using for example pulsed high energy green (532nm Nd:YVO₄ laser) or ultraviolet (335nm Nd:YAG laser) laser light pulses, with careful calibration of radiated power, pulse length and frequency to avoid excessive damage to the underlying bulk silicon in the substrate 1.

The openings 11 are in here particular made along an elongated parallel contact pattern (so called "fingers").

Here again, the proposed techniques can be performed in atmospheric or near atmospheric pressure conditions, with the possible use of a chemically neutral gas (helium, argon etc.) as atmosphere to avoid re-oxidizing of the silicon underlying the openings 11.

The opening of the oxide layer 9 is followed in a fifth step 109 by the deposition of a dopant containing silicon layer 13, containing a predetermined amount of dopant atoms (n- or p-dopant) on the front surface 3.

The dopant in the deposited dopant containing silicon layer 13 is preferably of the same n- or p-type as the dopant in the bulk of the silicon substrate 1, to benefit from lateral conductivity. The junction is then created at the rear side where additional layers can be added with greater thickness, as transparency is not an issue at the rear side .

The deposited dopant containing silicon layer 13 has in the present embodiment a thickness comprised between 5 and 30nm, preferably 15 to 25nm. This thickness is sufficient to slow down surface recombination, while the obtained passivation layer 9 remains sufficiently transparent for the obtained photovoltaic cell or device PV (see figure 8) to have a good efficiency.

The dopant containing silicon layer 13 may in particular be deposited by plasma enhanced chemical vapour deposition (PECVD) or atmospheric Pressure chemical vapour deposition (APCVD) of amorphous silicon and dopant (boron or phosphorus), here again possible in atmospheric or near atmospheric pressure conditions.

The silicon of the deposited dopant containing silicon layer 13 forms amorphous or microcrystalline silicon in the unopened areas, while it forms polycrystalline or crystalline silicon above the openings 11. This is due to the fact that the apparent poly- or monocrystalline silicon of the substrate 1 acts as a seed material during deposition.

In the amorphous or microcrystalline silicon, the grains are in a range of up to some microns (e.g. 0-50µm), while in the polycrystalline or crystalline silicon, the grains are in a range greater than at least a few hundreds of microns (e.g. 100µm and more).

A sixth step 111 (not represented in the figures), is the annealing of the dopant containing silicon layer 13 in a microcrystalline or polycrystalline silicon layer. This is achieved in a furnace, with temperatures between 800°C and 1100°C. The high temperatures of this annealing step 111 also cause part of the dopant contained initially in the amorphous silicon layer 13 to migrate in the underlying substrate 1 under and around the openings 11 (under the hatchings in figure 6).

The annealing step also improves the passivation effect of the passivation layer comprising the silicon oxide layer 9 and the dopant containing silicon layer 13.

The silicon oxide 9 acts as a diffusion barrier, so that during the annealing step 111, a higher dopant concentration is obtained in the portion of the substrate 1 immediately surrounding the openings 11. A certain fraction of the dopant can however tunnel through the oxide layer 9, so that a vertical dopant concentration gradient can be obtained just below the front surface 3.

The step of annealing the dopant containing silicon layer 13 combines the actual annealing with a spatially resolved doping of the front surface 3 in form of a light vertical dopant atom concentration gradient under said front surface 3, with higher values under the openings 11.

Also, the crystallization state of the annealed silicon from the initially dopant containing silicon layer 13 on top of the openings 11 (hatchings in figures 6 and after) is more ordered or less amorphous than the silicon from the initially amorphous dopant containing silicon layer 13 deposited above the silicon oxide layer 9. This ensures a more homogeneous junction with the metallic contacts (which will be created on top of the openings 11).

In covering the whole front surface 3 with the silicon oxide layer 9 and a micro- or polycrystalline silicon layer 13, a passivation effect is obtained, which negates the need for an additional, dedicated passivation layer and the need to remove (by etching or polishing) the polycrystalline silicon layer 9.

The excess of dopant around the front surface 3 will help slow down the recombination through opposite type dopant diffusion and surface recombination.

Other additional layers 15 of either passivation material or antireflection coating (ARC) can additionally be applied on top of the micro- or polycrystalline silicon layer 13 in a seventh step 113, for example silicon nitride SiNₓ, silicon carbide SiC or silicon oxide SiOₓ. Other possible materials include phospho- or borosilicate glass (PSG/BSG) as additional passivation or antireflective coating (ARC) layer 15. The result of this step is shown in figure 7.

In one particular embodiment, the phospho- or borosilicate glass contains respectively phosphorus or boron atoms acting as dopant atoms, in particular with a concentration comprised between 5.10¹⁸ and 2.10²¹cm⁻¹, and is deposited on top of the amorphous silicon layer 13 before the annealing step 111.

If the dopant contained in the dopant containing silicon layer 13 is boron or phosphorus, the phospho- or borosilicate glass can be used as an additional dopant source.

The annealing step 111 then causes dopant atoms to travel from the phospho- or borosilicate glass into the dopant containing silicon layer 13 undergoing its annealing process, and from the dopant containing silicon layer 13 into the underlying substrate 1.

Potentially higher dopant concentrations in the substrate 1 can thus be obtained.

The additional passivation and antireflection coating layer or layers 15 can in particular be deposited using plasma enhanced chemical vapor deposition PECVD if selected from the above mentioned materials.

Second openings or trenches 14 are formed in the passivation or antireflective coating layer 15 and the underlying polycrystalline silicon and boro- or phosphosilicate layers 9, 11.

The second openings 14 are obtained either by preserving the contact pattern free from the passivation or antireflective coating layer 15 (as in figure 7), or by performing a blanket deposition and then digging or etching the second openings 14. Said second openings 14 are for example dug using laser ablation or by jet printing etchant containing ink along the intended contact pattern, in particular with the same apparatus as the one used for digging the first openings or trenches 11 or a similar one.

To preserve the contact pattern free from the passivation or antireflective coating layer 15, a mask can be used.

As an alternative, if the passivation or antireflective coating layer 15 is added by plasma enhanced chemical vapour deposition, patterned electrodes for the generation of plasma can be used.

Suitable electrodes for depositing the passivation or antireflective coating layer 15 while specifically preserving the intended contact pattern are described in WO/2017/037064, entitled "PLASMA GENERATING APPARATUS AND METHOD OF MANUFACTURING PATTERNED DEVICES USING SPATIALLY RESOLVED PLASMA PROCESSING."

The patterned electrodes therein comprise recesses and protrusions facing the substrate 1. The voltage difference and working pressure are chosen so that the recesses and/or the protrusions form spatially isolated plasma chambers, under which the chemical deposition takes place on the substrate 1 in a spatially resolved way.

Using such electrodes and the associated process, the passivation or antireflective coating layer 15 can be deposited selectively on a desired area of the front surface 3, while preserving the contact pattern free from said additional passivation or antireflection coating layer 15.

In an eighth step 115 shown in figure 8, metallic contacts 17 are deposited, printed or brazed in the second openings 14.

The metal used for the metallic contacts 17 may be aluminum and/or silver, and in particular a eutectic mixture of two or more metals to cause melting of the metal of the contacts 17 without melting the silicon substrate 1.

As an alternative, the metallic contacts 17 may in particular be obtained by depositing a suspension or paste of metallic particles in a solvent, and a step of low temperature (300°C to 500°C) drying and curing of the metallic particles.

The metallic contacts 17 may as an alternative be plated specifically on the ablated pattern.

The metallic contacts 17 are deposited specifically in the laser-ablated second openings 14, above the areas where the dopant concentration in the doped silicon substrate 1 is higher. Therefore, even if some metallic atoms from the metallic contacts 17 migrate in the underlying substrate 1, the increased dopant content cancels the potential loss due to recombination during annealing or heat curing steps of the metallic contacts 17.

Figures 9 and 10 illustrate another embodiment of the method according to the invention, in which a paste 17a containing metallic and glass frit particles is used.

In said embodiment of the method, the second passivation or antireflective coating 15 is applied over the whole front surface 3, without preservation or ulterior realisation of the second openings 14. This is represented in figure 9 which is essentially identical to figure 7, with the second passivation or antireflective coating 15 covering the whole represented front surface 3.

In the following step of this embodiment, the paste 17a containing metallic and glass frit particles is applied on the contact pattern, for example using screen printing.

Then, a step of so called "firing through" takes place: the device is heated, to temperatures of 800-900°C or more, whereby the glass particles in the paste are at least partially molten, and cause the metallic particles to move through the passivation or antireflective coating 15 underlying the applied paste 17a, for example by forming a eutectic mixture with said coating 15.

The resulting photovoltaic device PV is then similar to the one represented is figure 8.

The figures 11 to 13 illustrate a possible treatment for the rear surface 5 of the photovoltaic device 15, here in particular to create back contacts 23 using the same method as the one for the front contacts 17.

The rear surface 5 is at first also textured, for example using the random pyramid method as illustrated in figure 3 in the case of the front surface 3 (figure 11). The random texturing may be performed as indicated in the case of the front surface (low concentration alkaline solution with isopropanol or an additive), in particular with similar temperature, concentration and timing parameters.

A thick layer of doped polycrystalline silicon 19 is then applied to the textured rear surface 5, as depicted in figure 12. The dopant contained in the thick polycrystalline silicon layer 19 is p-type in case of a n-type doped substrate 1, and n-type in case of a p-type doped substrate 1. The doped thick polycrystalline silicon layer 19 creates the junction at the back, where considerations about transparency are less important.

An oxide layer 9 is grown on the thick polycrystalline silicon layer 19, possibly using the same apparatus and conditions as for the front oxide layer 9. Openings are made in said oxide layer 9 along a back contact pattern.

A layer of dopant containing silicon 13 is then deposited on the opened oxide layer 9, which is doped with a p- or n-type dopant of the opposite type than the dopant in the dopant containing silicon layer 13 of the front surface 5.

The layer of dopant containing silicon 13 is then covered in a back surface antireflection coating 21 ("BARC" see figure 13). The back surface anti reflection coating 21 is for example silicon nitride SiN, silicon carbide SiC or silicate glass. The back surface antireflection coating 21 may also serve as passivation layer, or an additional, dedicated passivation layer may be implemented. The back surface antireflection coating 21 may in particular be a stack of several layers.

In a case where additional back-contacts are required, the back surface anti reflection coating 21 is then opened and the metallic back contacts 23 are deposited in the openings, as depicted in figure 13. The back contacts 23 are possibly deposited using the same methods as described for the front contacts 17.

Other embodiments can be obtained wherein the back surface 5 is not textured. In such processes, the back surface antireflection coating 21 is even more indicated.

The steps to form the junction and back surface 5 treatment are here presented as performed sequentially after the steps of the method 100 to obtain the front surface 3. However, steps performed on the front surface 3 and steps performed on the back surface 5 can be done in an alternating or simultaneous fashion, in particular when similar atmosphere, temperature and/or alignment conditions are used.

For example, the step 101 of random texturing of the front surface 3 may be performed at the same time and in the same bath as the step of texturing the back surface 5.

The different steps of the invention can be carried out almost exclusively under atmospheric pressure conditions, meaning that less vacuum chambers, decompression procedures and the inherent contamination prevention measures are required.

Also, the deposition steps can almost all be performed using plasma enhanced chemical vapour deposition (PECVD), which is much faster than, for example, low pressure chemical vapour deposition (LPCVD). In combination with laser ablation for the openings 11, 14 or use of a paste containing glass frit particles 17a, this means that the process 100 is potentially faster than the usual processes.

Therefore, the obtained photovoltaic device PV is potentially cheaper and faster to produce with the process 100 according to the invention than with the state of art processes.

## Claims

1. Method for manufacturing a photovoltaic device (15) having metallic front contacts (17), comprising the steps:
• providing a mono- or multicrystalline silicon substrate (1) comprising a predetermined quantity of a dopant and having a front surface (3) and a back surface (5), said dopant comprising either a p-type dopant or a n-type dopant,
• forming a silicon oxide layer (9) on the front surface (3) of the substrate (1),
• opening the silicon oxide layer (9) to form openings or trenches (11) according to a contact pattern,
• depositing a layer of dopant containing silicon (13) on the front surface (3), forming polycrystalline or crystalline silicon on top of the openings (11) and amorphous or microcrystalline silicon on the rest of the front surface (3),
• annealing the layer of dopant containing silicon (13),
• adding metallic contacts (17) on the contact pattern.

2. Method according to claim 1, wherein the dopant containing silicon (13) is deposited using plasma enhanced chemical vapour deposition.

3. Method according to claim 1 or 2, wherein the openings or trenches (11) are performed using laser ablation.

4. Method according to claim 1 or 2, wherein the openings or trenches (11) are performed using chemical etching.

5. Method according to any of claims 1 to 4, further comprising the steps of:
∘ depositing an additional passivation or antireflection coating layer (15),
∘ opening the additional passivation or antireflection coating layer (15) to create second openings (14) along the contact pattern,
∘ adding the metallic contacts (17) in the second openings (14).

6. Method according to any of claims 1 to 4, further comprising the steps of:
∘ depositing an additional passivation or antireflection coating layer (15) while preserving second openings (14) along the contact pattern,
∘ adding the metallic contacts (17) in the second openings (14).

7. Method according to any of claims 1 to 4, further comprising the steps of:
∘ depositing an additional passivation or antireflection coating layer (15),
∘ adding a paste (17a) containing metallic and glass frit particles on the intended contact pattern,
∘ firing through of the paste (17a) containing metallic and glass particles to obtain the metallic contacts (17).

8. Method according to claim 5, 6 or 7, wherein the additional passivation or antireflection coating layer (15) comprises at least one layer of material selected from the following list: silicon nitride SiNₓ, silicon carbide SiC, boro- or phosphosilicate glass.

9. Method according to claim 5, 6 or 7, wherein the dopant contained in the dopant containing silicon (13) is respectively boron or phosphorus, and the additional passivation or antireflection coating layer (15) comprises a layer of respectively boro- or phosphosilicate glass, deposited on the dopant containing silicon layer (13) before the step of annealing the layer of dopant containing silicon (13) to form a layer of polycrystalline silicon and cause a portion of the dopant to diffuse.

10. Method according to claim 9, wherein the phospho- or borosilicate glass contains respectively phosphorus or boron atoms as dopant, with a concentration comprised between 5.10¹⁸ and 2.10²¹cm⁻¹.

11. Method according to claim 5, 6, 7, 8 or 9, wherein the additional passivation or antireflection coating layer (15) is deposited using plasma enhanced chemical vapour deposition.

12. Method according to any of the preceding claims, wherein the dopant containing silicon layer (13) has a thickness comprised between 5 and 30nm, in particular between 15 and 25nm.
